# EUROPEAN PATENT APPLICATION

(11) **EP 1 744 458 A1**
(43) Date of publication of application: **17.01.2007**
(21) Application number: 06014234.6
(22) Date of filing: 10.07.2006
(51) Int. Cl.: H03K 19/00

(54) **Apparatus and methods for programmable slew rate control in transmitter circuits**

(30) Priority: 14.07.2005 US 183288
(71) Applicant: ALTERA CORPORATION, San Jose, California 95134 (US)
(72) Inventor: Asaduzzaman, Kazi, Fremont California 94555 (US); Shumarayev, Sergey Y., San Leandro California 94579 (US); Tran, Thungoc M., San Jose California 95133 (US); Wong, Wilson, San Francisco California 94134 (US); Patel, Rakesh, Cupertino California 95014 (US)
(74) Representative: Appelt, Christian W.

(57) **Abstract**

High speed transmitter drivers and other types of driver circuitry may be required to produce output signals with variable slew rates. Driver circuitry and methods for providing variable slew rate control are described. Pre-driver circuitry with variable slew-rate may be used to supply signals with variable slew rate at the driver input. The driver and/or pre-driver circuits may include transistors with variable drive strengths. The driver and/or pre-driver circuits may also include selectably enabled stages for varying the circuit drive strength. The pre-driver circuitry may be delay matched to maintain signal quality. Other circuitry and methods are also described.

## Description

### Background of the Invention

This invention relates to variable slew rate drivers for high speed transmitter circuitry.

Transmitter driver circuits are typically used to transmit signals between integrated circuits located on different integrated circuit devices. The signals may be transmitted through various transmission media, such as interconnect lines, integrated circuit pins, wires or circuit board traces, antennas, air, and other media. The transmitter driver may be required to produce an output signal that is sufficiently clear and of sufficient amplitude for the signal to be accurately interpreted by a remote receiver. Transmitters may use pre-emphasis to modify or amplify the signal before it is transmitted, to improve transmission accuracy.

In high speed applications, the transmitter driver may be required to function at very high bit rates which may reach speeds of 622 MBps (mega-bits per second) to 6.5 GBps (giga-bits per second), for example. In order to transmit data at such high rates, the transmitter driver may be required to switch its output from a logical low state to a logical high state (and vice-versa) in a very short period of time. The time it takes for the output signal to transition between two states, typically measured as the time it takes the output to transition from twenty (20) to eighty (80) percent of its final value (alternatively from ten (10) to ninety (90) percent), is known as the rise time or the fall time of the signal. The rate at which the transition takes place is known as the edge rate, or slew rate. For transmitters functioning at 6.5 GBps, corresponding to a signal period of 154 ps, the rise time and fall time of the signals may be required to be as small as 30 ps.

Transmitter drivers operating at high speeds produce electro-magnetic radiation known as electro-magnetic interference (EMI). EMI emitted by one device may interfere with the operation of other devices or circuitry, leading to data loss or other degradation in the operation of the devices or circuitry. The amount of EMI produced by a transmitter may be related to the slew rate of the transmitter, transmitters with higher slew rates producing greater EMI.

Certain transmission protocols, including XAUI, GIGE, PCI-Express, SONET OC-48, CEI/OIF and others, impose minimum and maximum slew rate requirements on the high-speed transmitters used to transmit signals using those protocols. Minimum slew rates are required to ensure that transmitted signals are sufficiently clear and have sharp enough transitions to be accurately interpreted at the receiver. Maximum slew rates are imposed to limit the EMI produced by the transmitters. These limits on EMI production may also be imposed by regulatory bodies such as the Federal Communications Commission (FCC) in the United States.

In transmitters used for data transfer at variable rates or using various transmission protocols, such as transmitters in programmable logic devices, variable slew rate control may be required.

### Summary of the Invention

In accordance with this invention, circuitry and methods provide variable slew rate control for transmitter drivers. Transmitter drivers may include switches or transistors of variable size and with varying drive strength, such as transistors with programmable numbers of legs. The output slew rate of the drivers may be selectably varied by selectively enabling or disabling a number of the legs of the transistors. Transmitter drivers may alternatively or additionally be coupled to pre-driver circuitry, the pre-driver circuitry having programmable slew rate control. The slew rate of the output signal of the transmitter driver may be adjusted by varying the output slew rate of the pre-driver circuit. The slew rate of the pre-driver circuit may be adjusted by selectably enabling or disabling different combinations of pre-driver stages. In a preferred embodiment, pre-driver circuitry used to drive different driver input signals is precisely delay-matched to ensure good output signal quality.

Further features of the invention, its nature and various advantages will be more apparent from the accompanying drawings and the following detailed description.

### Brief Description of the Drawings

FIG. 1 is a schematic block diagram of an illustrative transmitter driver unit in accordance with the invention.

FIGS. 2A and 2B are simplified circuit diagrams of illustrative implementations of transmitter driver units in accordance with the invention.

FIG. 3 is another simplified circuit diagram of an illustrative implementation of a transmitter driver unit including pre-emphasis functionality in accordance with the invention.

FIG. 4 is a schematic block diagram of another illustrative transmitter driver unit including pre-driver circuitry in accordance with the invention.

FIG. 5 is a simplified partial circuit diagram of a pre-driver used in a transmitter driver unit in accordance with the invention.

FIG. 6 is a simplified circuit diagram of an illustrative implementation of a transmitter driver unit including pre-driver circuitry in accordance with the invention.

FIG. 7 is a simplified block diagram of a system incorporating a transmitter driver unit in accordance with the invention.

### Detailed Description

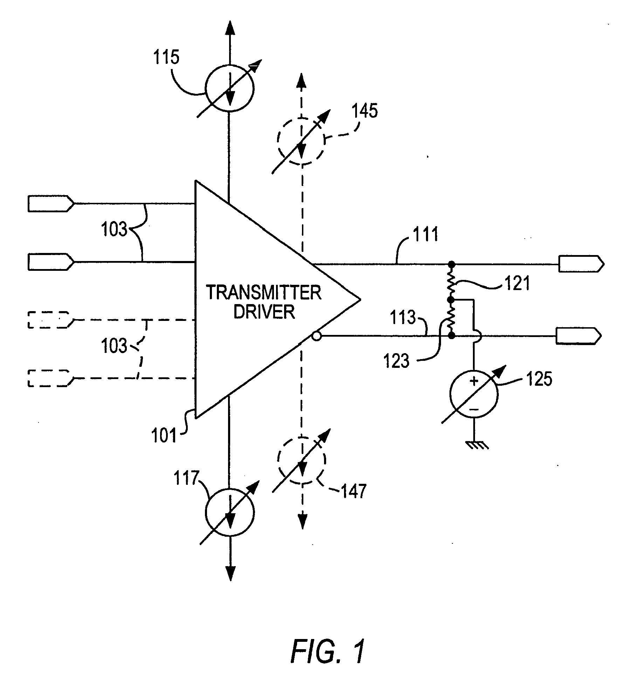

FIG. 1 shows a transmitter driver 101 that may be part of transmitter or transceiver circuitry included on an integrated circuit device, or in other circuitry used to transmit or drive signals. The integrated circuit device the transmitter is included on may preferably be a programmable device such as a programmable logic device (PLD), or an application specific integrated circuit (ASIC) or other type of integrated circuit device. The transmitter may also be included on other types of integrated circuit devices and other types of circuitry.

The transmitter driver 101 receives inputs from other regions of the integrated circuit device through one or more input leads 103. In a preferred embodiment, transmitter driver 101 may receive differential signals through two input leads 103. In another preferred embodiment, transmitter driver 101 may receive a main differential signal through two input leads, as well as pre-emphasis pre-tap and/or post-tap signals through two or more additional input leads 103. In the particular implementation shown in FIG. 1, the transmitter driver 101 may receive two differential input signals through four input leads, the input signals corresponding to a main differential input and a pre-emphasis differential input signal. The transmitter driver 101 may also have one or more output leads 111, 113. When used for differential signaling, two output leads may be used, the signals on the output leads being complementary.

One or more current sources 115, 117, 145, 147 may supply current to the transmitter driver 101. In one embodiment, the transmitter driver may be coupled to a pair of current sources 115 and 117 supplying current to a single main driver stage. In another embodiment, the transmitter driver may be coupled to two or more pairs of current sources 115, 117 and 145, 147, each pair of current sources driving a separate stage of the driver. The current sources may supply current of a particular amplitude. Alternatively, the current sources may be variable or selectably variable. Programmably variable current sources may be used to programmably vary the drive strength of the driver, to vary the amplitude of the output signal supplied by the driver, or to vary the gain of the main and pre-emphasis drivers. To increase the drive strength of the driver, the current supplied by the current sources may be increased. Similarly, to produce higher amplitude output signals at output leads 111 and 113, the value of current supplied by sources 115 and 117 may be increased. Finally, to vary the relative amplitude of the pre-emphasis input signal relative to the main input signal in the driver output signal, the value of current supplied by pre-emphasis current sources 145, 147 may be varied relative to that of the main current sources 115, 117. Each current source in a pair of current sources may drive current of the same amplitude.

In addition to the circuitry described above, transmitter driver 101 may also include impedance elements 121 and 123 and common mode voltage source 125. Impedance elements 121 and 123, which may be resistors coupled in series between output leads 111 and 113, may be used to match the output impedance of the transmitter driver with the impedance of circuitry the transmitter is coupled to. Such impedance matching is commonly used to improve the transmission efficiency of both transmitters and receivers. A voltage source 125 may be coupled between the impedance elements 121 and 123 to provide a stable common mode DC voltage at the output of the transmitter driver.

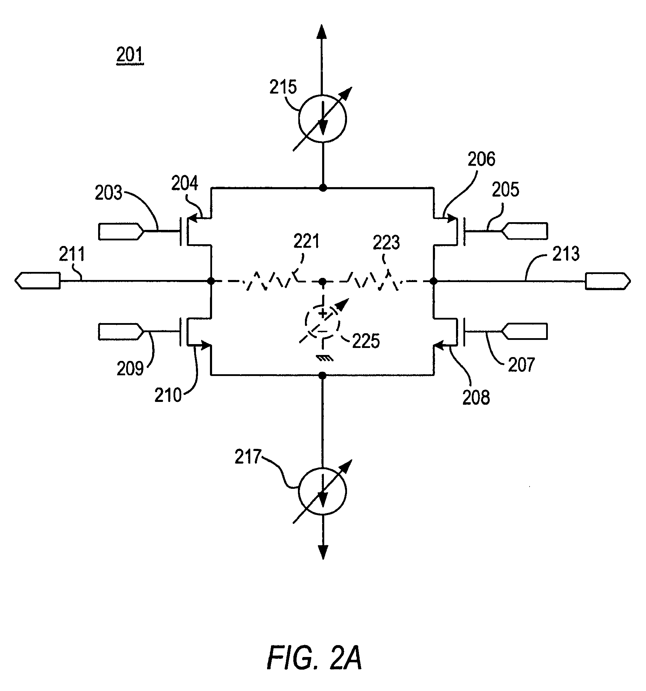

FIG. 2A shows an illustrative circuit diagram of a high-speed driver circuit 201 that may be used as a transmitter driver such as transmitter driver 101. High speed driver 201 receives four input signals at four input leads 203, 205, 207, and 209. Each input lead is coupled to the gate of a switch 204, 206, 208, 210. Upper switches 204 and 206, which may be P-type transistors such as PMOS or PNP transistors, have their source terminals coupled to each other and to current source 215. Current source 215 may be variable, or selectably or programmably variable, and may be substantially similar to current source 115 of FIG. 1 as described above. Each upper switch 204 and 206 may have its respective drain terminal coupled to the drain terminal of one of lower switches 210 and 208, and to one of output leads 211 and 213. Lower switches 210 and 208, which may be N-type transistors such as NMOS or NPN transistors, have their source terminals coupled to each other and to a second current source 217. Current source 217 may be substantially similar to current source 117 of FIG. 1.

In addition to the circuitry described above, impedance matching elements 221 and 223 may be coupled in series between output leads 211 and 213. These elements are substantially similar to impedance elements 121 and 123, and behave in substantially the same way. A voltage source 225 may be coupled between the impedance elements 221 and 223 to provide a stable common mode DC voltage at the output of the transmitter driver.

In a preferred embodiment, high speed driver circuit 201 may be operated as follows. Input leads 203 and 209 may receive substantially the same input signal, causing transistors 204 and 210 to be alternately turned on. When a voltage HIGH signal is applied to leads 203 and 209, upper switch 204 may be turned OFF while lower switch 210 may be turned ON. When a LOW voltage is applied to leads 203 and 209, upper switch 204 may be ON while lower switch 210 may be OFF. Similarly, input leads 205 and 207 may receive substantially the same input signal, causing switches 206 and 208 to be turned ON in alternation. In a preferred embodiment, the input signal applied to leads 205 and 207 is complementary to that applied to leads 203 and 209. In such an embodiment, when a voltage HIGH signal is applied to leads 203 and 209 (corresponding to a LOW signal at leads 205 and 207), switches 206 and 210 are turned ON while switches 204 and 208 are turned OFF. Conversely, when a LOW signal is applied to leads 203 and 209, switches 204 and 208 are ON while switches 206 and 210 are OFF. The current supplied by current sources 215 and 217 is thus routed diagonally through the circuit, alternately through switches 204 and 208 on the one hand, and through switches 206 and 210 on the other.

The high speed driver circuit 201 may be used to drive the differential signal received at its input leads at its output leads 211 and 213. Characteristics of the differential output signal measured between leads 211 and 213 may be influenced by the load coupled to output leads 211 and 213, by the amplitude of the current supplied by current sources 215 and 217, as well as by the drive strength of the switching transistors of switches 204, 206, 208, and 210.

In one embodiment, the slew rate of the output signal, corresponding to the maximum slope of output signal transitions, may be influenced by capacitive loading at leads 211 and 213. In order to vary the slew rate of the transmitter driver, capacitive elements of various sizes may be coupled at output leads 211 and 213. The maximal slew rate of the driver may be obtained with minimum capacitive loading. Progressively slower slew rates may be obtained by coupling larger and larger capacitive elements to the output leads. Selectably, dynamically or programmably variable slew rates may be obtained by coupling selectably, dynamically or programmably variable capacitive elements at leads 211 and 213. Integrated circuit capacitors, varactors, or off-chip capacitors may be used.

In another embodiment, the slew rate of the output signal may be influenced by the drive strength of the switches forming the driver. The drive strength of the switches of the high speed driver may be varied by adjusting the size of the transistors forming the switches, or by adjusting the number of legs of the transistors. In order to increase the slew rate of the output signal, larger transistors or transistors comprising a greater number of legs may be used to increase the total drive strength of the switches. Conversely, in order to reduce the slew rate of the output signal, smaller transistors or transistors comprising fewer number of legs may be used to reduce the drive strength of the switches.

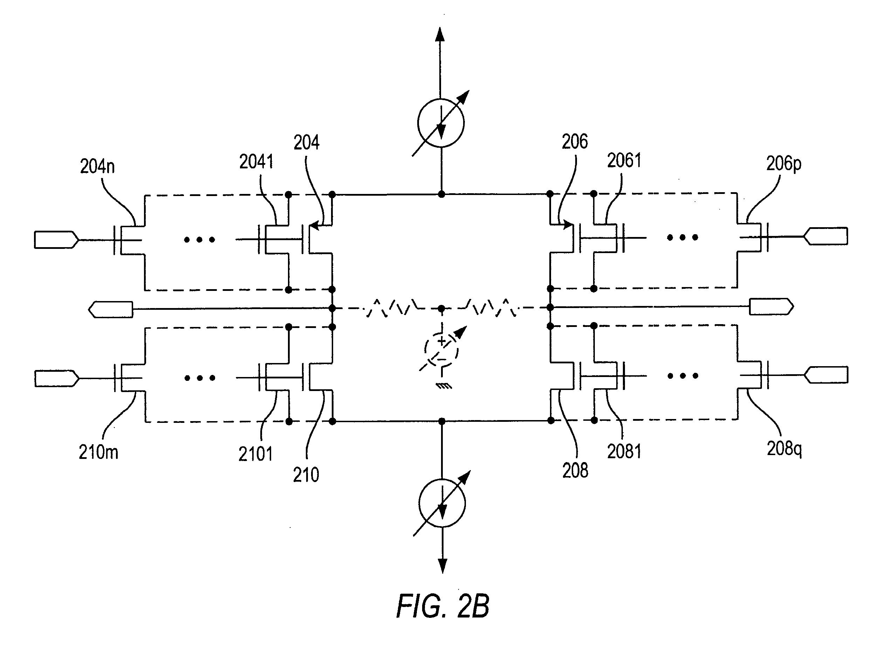

Selectable or programmable slew rate control may be obtained by including selectable multiple leg transistors in the switches forming the driver stage. Selectable multiple leg transistors have multiple legs which may be selectably coupled or de-coupled depending on the requirements of the circuit. In the particular transmitter driver implementation shown in FIG. 2B, transistors 204, 206, 208, and 210 may have such selectable multiple legs (2041-204n; 2061-206p, etc.). The number of legs of each transistor may be increased to increase the slew rate of the output signal, and the number of legs may be decreased to decrease the slew rate of the output signal. Control circuitry (not shown) may be used to selectably vary the number of enabled legs of each transistor, or to selectably vary the size of the switches. Note that control circuitry or other circuitry associated with the driver may dynamically or programmably vary the characteristics of the selectable switches, or otherwise control the output signal slew rate.

As noted previously, the output drive strength of high speed driver 201 may be varied by adjusting the current supplied by current sources 215 and 217. In embodiments in which output drive strength is variable, the driver switches may be formed of multiple leg transistors. When large output drive strength is required, multiple legs of the transistors are enabled to allow greater current to flow through the circuit. Conversely, when only little drive strength is required, few legs are enabled to reduce losses in the driver circuit. In embodiments in which such selectable multiple leg transistors are already included in the driver circuitry, selectably variable slew rate control may be obtained with minimal additional circuitry.

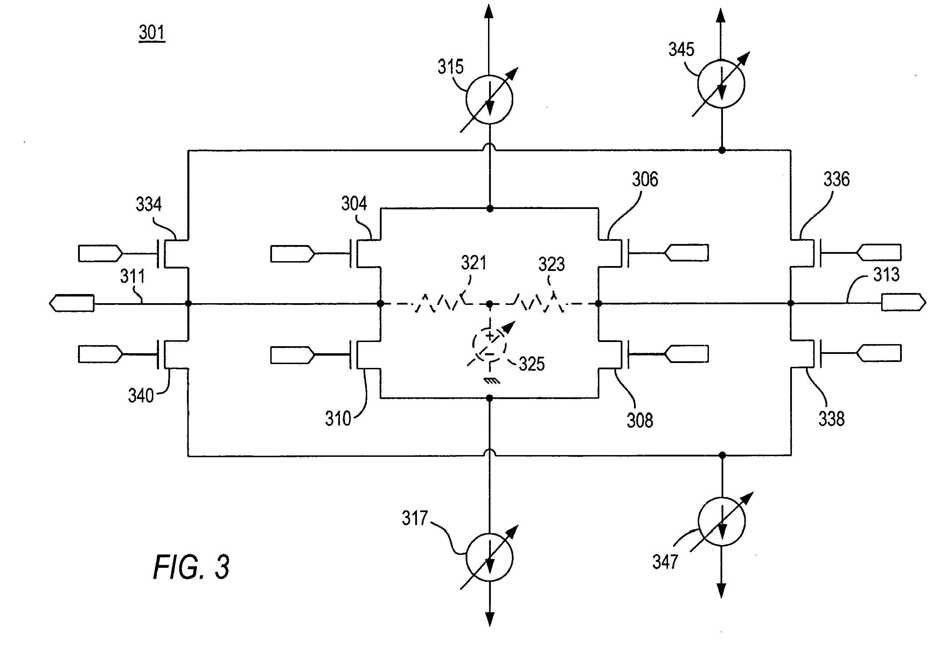

FIG. 3 shows a high speed driver circuit 301 which operates substantially similarly to high speed driver circuit 201. High speed driver circuit 301 additionally contains circuitry for driving a pre-emphasis signal. Circuit 301 contains two parallel stages, each stage substantially resembling circuit 201 and operating in substantially the same fashion. The elements of each of the parallel stages of circuit 301 are numbered so as to correspond to their corresponding elements in circuit 201, their numbers being one hundred (100) or one-hundred and thirty (130) units higher than those of circuit 201. Thus, by way of example, switches 304 and 334 operate in substantially the same way as switch 204.

As in circuit 201, each of the parallel high speed driver stages of circuit 301 may receive a complementary input signal at their input leads, and may drive a complementary output signal at their output leads 311 and 313. The current signals driven by each of the parallel stages may combine at their common output leads 311 and 313, producing a single differential output signal at leads 311 and 313. The output signal may correspond to the sum of the signals driven by each stage. The output signal may also correspond to the weighted sum of the input signals received by each of the stages, the weights of the sum corresponding to the amplitude of the currents supplied by the respective current sources 315, 317 and 345, 347 of each stage.

The circuit of FIG. 3 may include transistors with selectable numbers of legs, as discussed in the context of FIG. 2B. In order to selectably vary the slew rate of the signal produced by the high speed driver of FIG. 3, the transistors of both parallel driver circuits comprising the circuit 301 may have selectable numbers of legs. As in FIG. 2B, the numbers of enabled legs may be increased in order to increase the slew rate of the driver, or decreased in order to decrease the slew rate. Capacitive loading at output leads 311 and 313 may also be used to vary the output slew rate of driver 301.

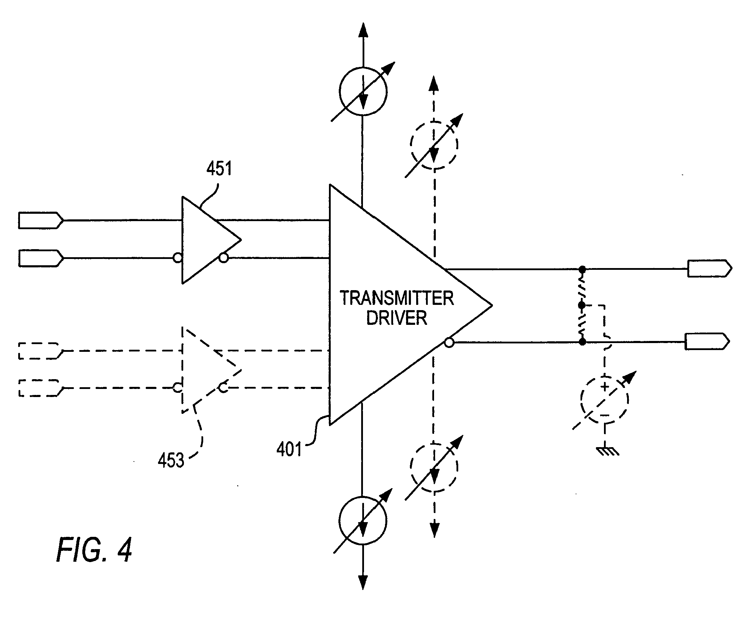

A different, or complementary approach to providing a variable slew rate control driver involves using pre-drivers such as pre-drivers 451 and 453 shown in FIG. 4. FIG. 4 shows a transmitter driver 401 similar to that shown in FIG. 1. In addition to the circuit elements shown in FIG. 1, transmitter driver 401 is coupled to one or more pre-drivers 451 and 453. Transmitter driver 401 may, for example, be coupled to one differential pre-driver for each differential input signal the transmitter driver receives. The pre-drivers may be used to vary the slew rate of the signals applied to the input of the transmitter driver. Varying the slew rate of the input signals to the transmitter driver may cause the slew rate of the output signal produced by the driver to vary correspondingly.

In one embodiment, the pre-drivers 451 and 453 may take the form of pass transistors with variable drive strengths. In this embodiment, the drive strength of the pass transistors may be controllable by a slew rate control signal. The slew rate control signal may, for example, vary the number of active legs comprising each transistor switch in order to adjust the slew rate of the transmitter driver.

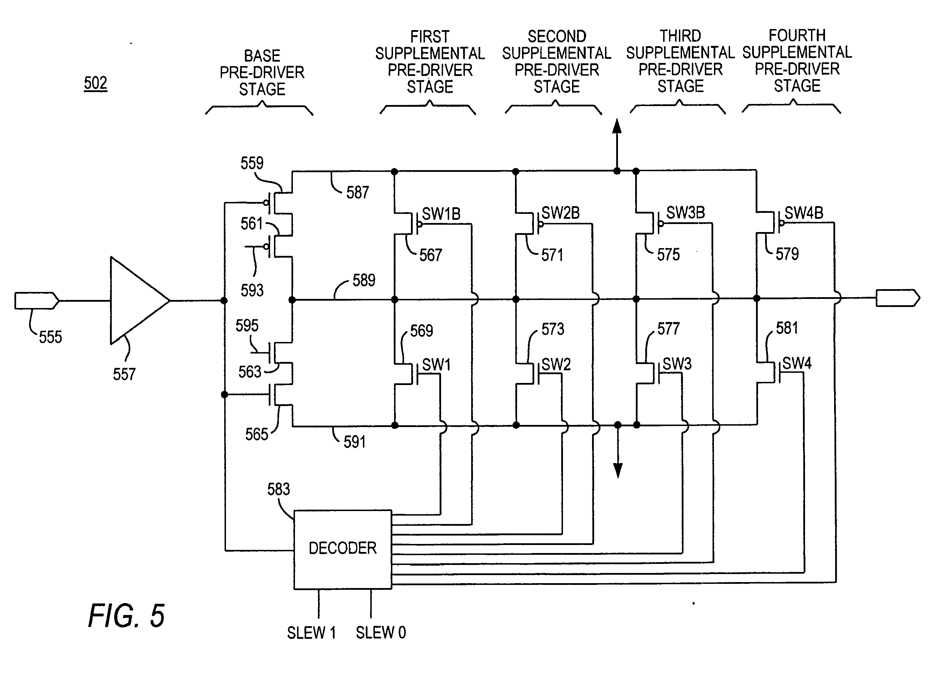

In another embodiment, pre-drivers 451 and 453 may include circuitry such as that shown in FIG. 5, which provides the ability to selectably vary the output slew-rate of the pre-drivers. Note that circuit 502 shown in FIG. 5 is a single-input, single-output pre-driver, and that two such circuits would be required to form a differential pre-driver such as pre-driver 451 or 453. Pre-driver circuit 501 receives a single-ended input signal at lead 555. The input lead 555 may be coupled to an optional buffer 557. Buffer 557 may be a tri-state buffer used to selectably couple or decouple pre-driver circuitry from the input.
Buffer 557 may also be an inverter, or any other type of buffer. The output of buffer 557 may be coupled to a base driver stage which may be formed of a first switch, such as an n-type transistor, coupled between the ground node 591 and the output node 589, and a second switch, such as a p-type transistor, coupled between the power supply node 587 and the output node 589. Both switches may be controlled by the signal at the output of buffer 557, or by the input signal on lead 555. Alternatively, the inverter may be formed of a first switch including two or more n-type devices 563 and 565 coupled in series, and a second switch including two or more p-type devices 559 and 561 coupled in series. Other switch and transistor configurations may also be used. The exemplary embodiment of FIG. 5 shows switches including two transistors each. In this embodiment, the additional transistors 561 and 563 may serve to reduce the slew rate of the base driver stage. Note that the gate terminals 593 and 595 of the additional devices may be biased by appropriate DC voltages. In the particular implementation of FIG. 5, node 593 may be coupled to ground and node 595 may be coupled to the power supply to keep both devices ON at all times.

In addition to the base driver stage, circuit 502 may include multiple supplemental driver stages coupled in parallel with the base driver stage. Each supplemental driver stage may include a first switch, such as a p-type transistor, coupled between the power supply 587 and output 589 and a second switch, such as an n-type transistor, coupled between the output 589 and ground 591. Each supplemental driver stage may be selectably enabled or disabled by a decoder 583, in order to selectably adjust the slew rate at the output 589 of the pre-driver circuit. When a particular supplemental driver stage is enabled, its switches may be controlled by the buffer 557 output signal or another signal related to the pre-driver input signal. When a particular supplemental driver stage is disabled, it may be tri-stated or its switches placed in a substantially non-conducting state. The decoder 583 may receive one or more signals SLEW[0-1] indicative of the desired output slew rate. Signals SLEW[0-1] may be stored in memory on the integrated circuit device, or may be generated on the integrated circuit device or elsewhere. The decoder may enable or disable any of the supplemental pre-driver stages depending on the input signals SLEW[0-1] it receives. The decoder may supply the enabled stages with a signal related to the pre-driver input signal of lead 555, or to the buffer 557 output signal.

In order to produce different output slew rates, different numbers or combinations of supplemental pre-driver stages are enabled. The smallest slew rate is achieved by disabling all supplemental pre-driver stages, the slew rate in this case being limited by the drive strength of the transistors of the base pre-driver stage. The highest slew rate is achieved by enabling all supplemental pre-driver stages, and allowing maximum current to be supplied to the load through the base and all of the supplemental pre-driver stages. Intermediate slew rates are achieved by enabling different numbers or combinations of supplemental pre-driver stages. Each supplemental pre-driver stage may include transistors of different sizes or with variable numbers of legs, enabling each supplemental pre-driver stage to have a different drive strength. Note that while four supplemental driver stages are shown in FIG. 5, the pre-driver may include more or fewer supplemental driver stages in order to provide a large range of output slew rates.

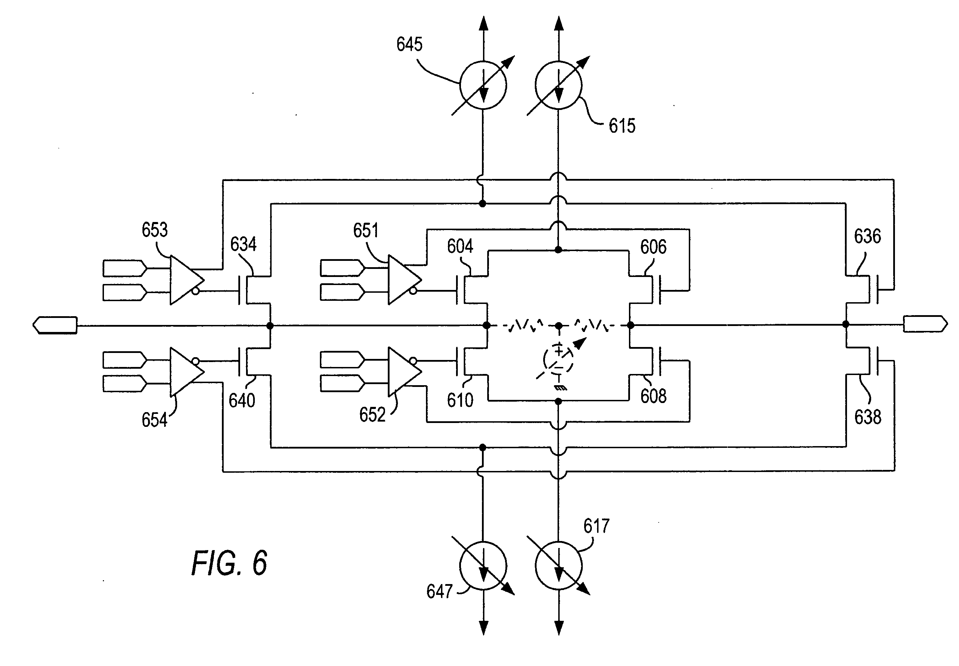

FIG. 6 shows an exemplary transmitter driver circuit in accordance with the invention. The transmitter driver 601 of FIG. 6 is similar to those shown in FIGS. 3 and 4. Transmitter driver 601 has a main driver stage including switches 604, 606, 608, and 610, and a pre-emphasis stage including switches 634, 636, 638, and 640. The pre-emphasis stage may correspond to a pre-tap or a post-tap stage. While the embodiment of FIG. 6 shows a single pre-emphasis stage, other embodiments may include more or fewer pre-emphasis stages depending on the requirements of the driver circuit. The pre-emphasis stage of driver 601 includes switches 634, 636, 638, and 640, and an associated pair of current sources 645 and 647.

Each driver stage may be driven by pre-driver circuitry in accordance with the principles of the invention. In the particular embodiment of FIG. 6, upper switches 604 and 606 of the main driver stage, which may be p-type transistors, are driven by a first pre-driver 651. Lower switches 608 and 610, which may be n-type devices, may be driven by the same pre-driver circuit 651 or by a different pre-driver circuit 652 (as shown). Because of the different characteristics of n-type and p-type devices, including differences in device size, different pre-driver circuits may be used to drive the different transistor switches. Similarly to the configuration of the main driver stage, upper switches 634 and 636 of the pre-emphasis stage may be driven by pre-driver circuit 653, while lower switches 638 and 640 may be driven by pre-driver circuit 654.

In order to ensure high signal quality at the output of the various pre-driver circuits 651-654, it may be preferable for the switches of each stage of the driver circuit to receive precisely synchronized input signals. To minimize inter-symbol interference (ISI), duty cycle distortion, jitter reduction and other signal quality degradation, it may therefore be desirable to match timing characteristics of the various pre-driver circuits used in the transmitter driver. The transmission delay between the inputs of pre-driver circuits 651 and 652 and switches 604, 606, 608, and 610 they control may be matched, preferably within 3-5 ps of each other for proper transmitter operation at 6.5 GBps. Similarly, the transmission delay between the complimentary inputs and complimentary outputs of differential pre-drivers such as pre-drivers 651 and 652 may be matched. The transmission delay between the inputs of other pre-driver circuits 653, 654 and the driver switches they control may be matched to the delay of the main stage pre-drivers. Note that the delay matching may also apply to pre-drivers 451 and 453 described in relation to FIG. 4.

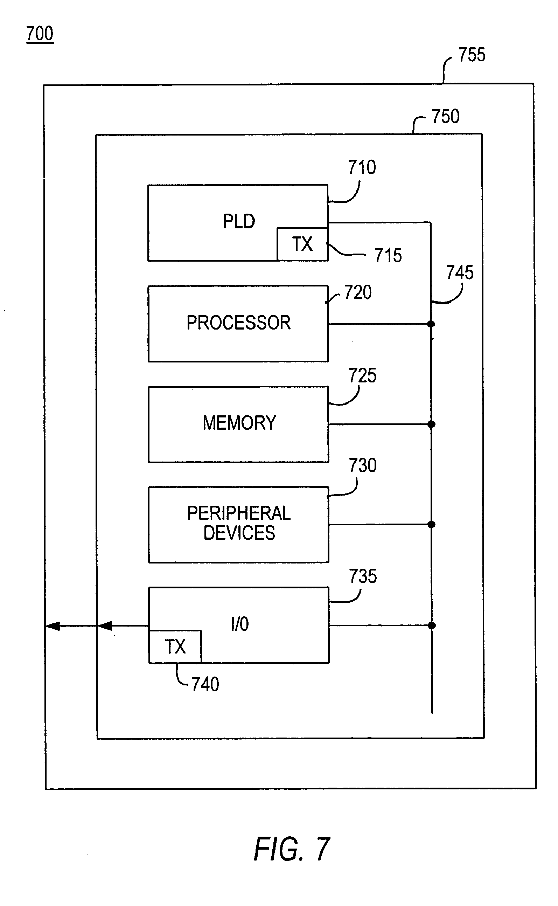

FIG. 7 shows an illustrative system employing the transmitter driver circuitry of the invention. System 700 may be a digital processing system and may include programmable logic device (PLD) 710, which may include I/O circuitry, including transmitter circuitry 715 in accordance with the invention. System 700 may also include one or more of a processor 720, memory 725, peripheral devices 730, and system level I/O circuitry 735 which may include transmitter circuitry 740 in accordance with the invention. Transmitter circuitry 740 may be used to transmit signals to other locations or devices on system 700, or to locations outside of system 700. These components may be coupled together by a system bus 745, and contained in an end-user system 755.

System 700 can be used in a wide variety of applications, such as computer networking, data networking, instrumentation, video processing, digital signal processing, or any other application where transmitter circuitry may be used. Note that system 700 is only exemplary and in no way should be construed to limit the true scope and spirit of the invention. The transmitter circuitry of the invention may be used in integrated circuits and devices other than PLDs.

It will be understood that the foregoing is only illustrative of the principles of the invention, and that various modifications can be made by those skilled in the art without departing from the scope and spirit of the invention. For example, the particular circuit implementations shown herein are only illustrative, and other constructions can be used instead if desired.

## Claims

1. A transmitter driver circuit having selectable slew rate comprising:
a pre-driver circuit for producing a driver input signal with variable slew rate, the pre-driver circuit comprising:
a plurality of pre-driver stages selectively operable to drive a pre-driver output signal related to a signal received at an input of the pre-driver circuit; and
control circuitry responsive to at least one slew rate control signal, the control circuitry operative to selectively enable the pre-driver stages to vary the pre-driver output signal slew rate; and
a driver circuit receiving a slew rate controlled signal from the pre-driver circuit, said driver circuit producing a driver output signal with a slew rate related to the slew rate of the pre-driver output signal.

2. The transmitter driver of claim 1, further comprising:
a second pre-driver circuit for producing a second driver input signal with variable slew rate; and wherein the driver circuit further receives a slew rate controlled signal from the second pre-driver circuit, and the driver circuit produces a driver output signal with a slew rate related to the slew rate of the pre-driver and second pre-driver output signals.

3. The transmitter driver of claim 2, wherein the transmission delay between the inputs of the pre-driver and second pre-driver circuits and the outputs of the pre-driver and second pre-driver circuits are matched.

4. The transmitter driver of claim 2, wherein the second pre-driver circuit is used to drive a pre-emphasis signal.

5. The transmitter driver of claim 1, wherein the pre-driver output signal is a differential signal.

6. The transmitter driver of claim 1, wherein the driver circuit comprises switches with variable drive strengths, the drive strength of the switches being variable in response to the slew rate control signal.

7. The transmitter driver of claim 1 further comprising:
a variable capacitive element coupled to the output of the transmitter driver, the capacitance of the element being varied in response to the slew rate control signal.

8. The transmitter driver of claim 1, wherein the transmitter driver is operative at variable bit rates in excess of about 622 MBps.

9. The transmitter driver of claim 1, wherein the transmitter driver is operative at variable bit rates up to about 6.5 GBps.

10. The transmitter driver circuit of claim 1, wherein the selectable slew rate is programmably selectable.

11. A programmable logic device comprising the transmitter driver circuit of claim 1.

12. An integrated circuit device comprising the transmitter driver circuit of claim 1.

13. A digital processing system comprising:
processing circuitry;
a memory coupled to said processing circuitry; and
an integrated circuit device as defined in claim 12 coupled to the processing circuitry and the memory.

14. A printed circuit board on which is mounted an integrated circuit device as defined in claim 12.

15. A method of varying the output slew rate of a transmitter driver, the method comprising:
varying the output slew rate of a pre-driver circuit by selectively enabling a plurality of pre-driver circuit stages in response to a slew rate control signal;
applying an input signal to an input of the pre-driver circuit to produce a pre-driver output signal with a variable slew rate; and
applying the pre-driver output signal to the transmitter driver, to produce a driver output signal with a desired slew rate.

16. The method of claim 15 further comprising:
varying the output slew rate of a second pre-driver circuit by selectively enabling a plurality of pre-driver circuit stages in response the slew rate control signal;
applying a second input signal to an input of the second pre-driver circuit to produce a second pre-driver output signal with a variable slew rate; and
applying the second pre-driver output signal to the transmitter driver, to produce a driver output signal responsive to the pre-driver and second pre-driver output signals.

17. The method of claim 16, further comprising:
matching the transmission delay between the inputs of the pre-driver and second pre-driver circuits and the outputs of the pre-driver and second pre-driver circuits.

18. The method of claim 15 further comprising:
varying the output slew rate of the transmitter driver by selectively varying the drive strength of switches in the transmitter driver in response to a slew rate control signal.

19. A driver circuit for programmable slew rate control comprising:
first and second switches with first terminals coupled to each other and to a first current source, second terminals coupled to driver input leads, and with the third terminal of the first switch coupled to a first driver output lead and the third terminal of the second switch coupled to a second driver output lead, wherein the first and second switches have variable size;
third and fourth switches with first terminals coupled to each other and to a second current source, with second terminals coupled to driver input leads, and with the third terminal of the third switch coupled to the first driver output lead and the third terminal of the fourth switch coupled to the second driver output lead, wherein the third and fourth switches have variable size; and
control circuitry responsive to at least one slew rate control signal, the control circuitry operative to vary the size of the first, second, third and fourth switches.

20. The driver circuit of claim 19, wherein the first, second, third and fourth switches comprise transistors with selectable numbers of legs, and wherein the control circuitry is operative to selectively enable a variable number of legs of the transistors.
